# EUROPÄISCHE PATENTANMELDUNG

(11) **EP 3 200 349 A1**
(43) Veröffentlichungstag der Anmeldung: **02.08.2017**
(21) Anmeldenummer: 16153147.0
(22) Anmeldetag: 28.01.2016
(51) Int. Cl.: H03K 17/96

(54) **KAPAZITIVE BENUTZERSCHNITTSTELLE**

(71) Anmelder: RAFI GmbH & Co. KG, 88276 Berg (DE)
(72) Erfinder: Fischer, Helmut, 88255 Baienfurt (DE)
(74) Vertreter: Engelhardt & Engelhardt

(57) **Zusammenfassung**

Bei einer kapazitiven Benutzerschnittstelle (1) zur Erzeugung mindestens eines elektrisch auswertbaren Schaltsignals, durch das ein elektrisches Gerät, beispielsweise ein Telefon, eine Werkzeugmaschine, ein Kühlschrank oder dergleichen manuell bedienbar ist,
- mit einer in einem Gehäuse (3) angeordneten Abdeckplatte (4), die aus einem elektrisch nicht leitfähigen Werkstoff hergestellt ist, und durch die mindestens eine Schaltfläche (5) erkennbar und von außen bedienbar ist,
- mit mindestens einer ein Kapazitätsfeld erzeugende Sensorfläche (6), die aus einem elektrisch leitfähigen Werkstoff hergestellt und die auf eine im Inneren des Gehäuses (3) an vorgesehenen Träger- oder Leiterplatten (7) aufgebracht ist und die fluchtend zu der jeweiligen Schaltfläche (5) ausgerichtet ist und
- mit einer Spannungsquelle (14) zur Bestromung der Sensorfläche (6),
soll eine Oberflächenstruktur zur Verfügung gestellt sein, die aufgrund unterschiedlicher Werkstoffeigenschaften für den Tastsinn des Benutzers andersartige Schalthaptiken der Abdeckplatte (4) aufweisen und einen optisch hochwertigen Eindruck erzeugen.

Diese Aufgabe ist dadurch gelöst, dass auf oder in der Abdeckplatte (4) mindestens ein flächig ausgestalteter Schirm (11) vorgesehen ist, der aus einem elektrisch leitfähigen Werkstoff besteht, und dass in den Schirm (11) und/oder seitlich benachbart zu dem jeweiligen Schirm (11) mindestens eine den Schirm (11) vollständig durchdringende Durchbrechung (12) bzw. ein Spalt (12') vorhanden ist, die zu der jeweiligen Schaltfläche (5) fluchtend und/oder seitlich versetzt verläuft.

## Beschreibung

Die Erfindung bezieht sich auf eine kapazitive Benutzerschnittstelle zur Erzeugung mindestens eines elektrisch auswertbaren Schaltsignals, durch das ein elektrisches Gerät, beispielsweise ein Telefon, eine Werkzeugmaschine, ein Kühlschrank oder dergleichen manuell bedienbar ist, nach dem Oberbegriff des Patentanspruches 1.

Eine derartige Benutzerschnittstelle kann beispielsweise aus der EP 2 645 571 A1 entnommen werden. Die im Inneren des Gehäuses angeordneten Sensorflächen sind bestromt und bestehen aus einem elektrisch leitfähigen Werkstoff, so dass durch diese Sensorfläche eine erste kapazitiv aufgeladene Platte gebildet ist. Das von den Sensorflächen abgestrahlte elektrische Feld - im weiteren Kapazitätsfeld genannt -, weist dabei in Richtung einer Abdeckplatte und tritt durch diese hindurch. Sobald beispielsweise ein menschlicher Finger oder ein Bedienstift in Richtung der Abdeckplatte von außen zugeführt bzw. bewegt ist, verändert sich das Kapazitätsfeld der jeweiligen darunterliegenden Sensorfläche. Eine solche Veränderung der Kapazität der Sensorfläche ist durch eine entsprechende Mess- und Schaltelektronik ausgewertet und ein elektrisches Schaltsignal für ein elektrisches Gerät ist generiert. Die Sensorfläche ist dabei einem Symbol- oder Schaltfeld zugeordnet, das zwischen der Sensorfläche und der Abdeckplatte verläuft. Im Inneren des Gehäuses, geschützt durch die Abdeckplatte sind mehrere Beleuchtungsmittel, beispielsweise LEDs, vorgesehen, die fluchtend zu dem jeweiligen Schaltfeld angeordnet sind, so dass diese durch das Beleuchtungsmittel ausgeleuchtet werden können.

Nachteiliger Weise sind die elektrischen Baueinheiten, beispielsweise die Sensorfläche, die Leiterplatte und dergleichen, oftmals von außen visuell erkennbar, wenn nämlich der Lichteinfall entsprechend gerichtet ist. Durch geeignete Absorptionsmaßnahmen können diese Effekte reduziert werden, jedoch entsteht von außen der optische Eindruck, dass eine ästhetisch nicht ansprechende Umgebung für die jeweiligen Schaltflächen, die dann in schwarz gehalten ist, entsteht.

Es ist allgemein bekannt, dass elektrisch leitfähige, insbesondere metallische, Flächengebilde, die zwischen dem Benutzer und der Sensorfläche eines kapazitiven Sensors angeordnet sind, diesen abschirmen. Dadurch ist das elektrische Feld der Sensorfläche abgelenkt oder -gestützt und eine Funktionalität der Benutzerschnittstelle ist nicht gegeben.

Da die Abdeckplatte oftmals aus einem transparenten Kunststoffmaterial gefertigt ist, weist die jeweilige Schaltfläche einen entsprechenden künstlichen Eindruck bei dem Berühren der Abdeckplatte auf, und zwar insbesondere wenn der Benutzer mit seinem Finger die Abdeckplatte berührt. Eine andere Materialwahl für die Abdeckplatte konnte bislang lediglich aus Werkstoffen gebildet sein, die keine elektrische Leitfähigkeit und somit eine geringe Wärmeleitfähigkeit aufweisen, da anderenfalls die zur Bedienung erforderliche Kapazitätsfeldveränderung nicht eintritt, denn die Werkstoffe, die elektrisch leitfähig sind, schirmen das von der Sensorfläche in Richtung der Abdeckplatte ausgesandte Kapazitätsfeld ab.

Es ist daher Aufgabe der Erfindung, eine kapazitive Benutzerschnittstelle der eingangs genannten Gattung bereit zu stellen, die sowohl eine zuverlässige Bedienbarkeit aufweist, als auch gleichzeitig eine Oberflächenstruktur zur Verfügung stellt, die aufgrund unterschiedlichster Werkstoffeigenschaften für den Tastsinn des Benutzers andersartige Schalthaptiken aufgrund der Oberflächenbeschaffienheit der Abdeckplatte aufweisen und einen optisch hochwertigen Eindruck erzeugen.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass auf oder in der Abdeckplatte mindestens ein flächig ausgestalteter Schirm vorgesehen ist, der aus einem elektrisch leitfähigen Werkstoff besteht, und dass in dem Schirm und/oder seitlich benachbart zu dem jeweiligen Schirm mindestens eine den Schirm vollständig durchdringende Durchbrechung bzw. ein Spalt vorhanden ist, die zu der jeweiligen Schaltfläche fluchtend und/oder seitlich versetzt verläuft, kann die Sensorfläche eine Bedienung durch den Benutzer erfassen und dem Benutzer wird während der Berührung der Abdeckplatte suggeriert, dass die Schaltfläche metallisch kalt ist. Der Schirm weist nämlich eine hohe Wärmeleitfähigkeit auf, wodurch die Wärme von der Hautoberfläche des Benutzers schnell abtransportiert wird und sich somit der Schirm kalt anfühlt, wohingegen der Spalt zwischen dem benachbarten Schirm als relativ warmer Kunststoff wahrgenommen wird, so dass beim Überfahren der Abdeckplatte unterschiedliche Tastsinne entstehen.

Darüber hinaus ist es besonders vorteilhaft, wenn in die Abdeckplatte für jeden Schirm eine Aussparung eingearbeitet ist, in die der jeweilige Schirm fest einsetzbar und in diesem lageorientiert gehalten ist. Der jeweilige Schirm ist durch die elektrisch nicht leitfähige Abdeckplatte isoliert von den jeweiligen benachbarten Schirmen gehalten. Zwischen den räumlich voneinander getrennten Schirmen entsteht folglich ein um den jeweiligen Schirm umlaufender Spalt, der von einem elektrisch nicht leitfähigen Werkstoff gebildet ist. Somit kann das von der darunter angeordneten Sensorfläche durch den jeweiligen Spalt bzw. die in den jeweiligen Schirm eingearbeiteten Durchbrechung hindurchdringen, so dass sich bei der Annäherung bzw. Berührung der jeweiligen Schaltfläche durch einen menschlichen Finger eine Kapazitätsfeldveränderung messen lässt, die zu der gewünschten Schaltfunktion ausgewertet und umgesetzt ist. Ecken, Fugen oder Kanten können ganz oder teilweise auf der dem Benutzer zugewandten Oberfläche vermieden werden wodurch sich die kapazitive Benutzerschnittstelle bestmöglich reinigen bzw. sauber halten lässt.

Der Schirm mit den durchdringenden Durchbrechungen kann flächig an die Abmessung der Abdeckplatte angepasst sein und sich über deren gesamte Fläche erstrecken. Auch kann der Schirm vereinzelt auf oder in die Abdeckplatte eingebracht bzw. angeordnet sein, so dass zwischen zwei benachbarten Schirmen stets ein Spalt vorhanden ist.

Darüber hinaus ist es besonders vorteilhaft, wenn die Oberfläche der jeweiligen Schirme in einer Ebene mit der Oberfläche der Abdeckplatte verlaufen. Der Schirm kann eine plane, konkav oder konvex gekrümmte oder gewellte Außenkontur aufweisen, die an der von der Abdeckplatte gebildeten Ebene überstehen oder in diese verlaufen. Der Schirm kann weiterhin eine oder mehrere erhabene Strukturen, beispielsweise Reliefschrift, Punktschrift oder Symbole aufweisen, so dass die Bedeutung der Schaltflächen durch den Tastsinn des Benutzers erfasst werden kann.

Der Schirm ist vorzugsweise aus einem Metall hergestellt, das eine besonders hohe Wärmeleitfähigkeit aufweist.

Die Abdeckplatte kann aus einem transparenten oder semitransparenten Werkstoff gebildet sein, so dass ein oder mehrere Beleuchtungsmittel in dem Gehäuse angeordnet werden können, deren ausgestrahlte Lichtwellen durch die Abdeckplatte hindurch für den Benutzer wahrnehmbar sind. Zwischen den Beleuchtungsmitteln zweier benachbarter Schaltflächen kann ein Abstandshalter angeordnet sein, der benachbarte Schaltflächen lichtdicht trennt.

In der Zeichnung sind zwei erfindungsgemäße Ausführungsbeispiele einer kapazitiven Benutzerschnittstelle dargestellt, die nachfolgend näher erläutert sind. Im Einzelnen zeigt:

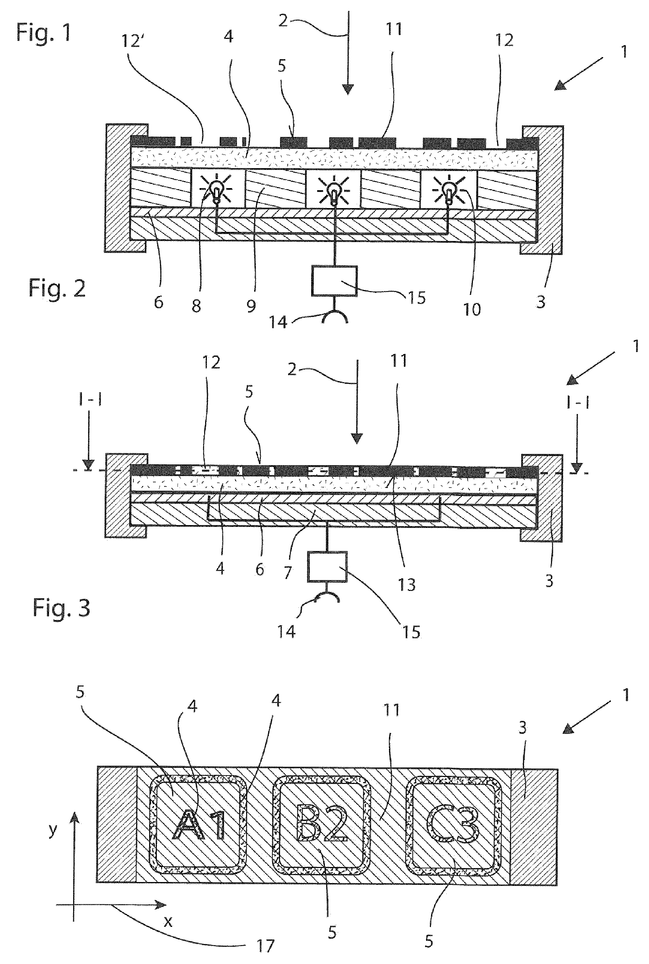

- Figur 1: ein erstes Ausführungsbeispiel einer kapazitiven Benutzerschnittstelle, bestehend aus einer Abdeckplatte aus Kunststoff oder Glas, die zwischen der Schaltfläche und einer ein Kapazitätsfeld erzeugenden Sensorfläche in einem Gehäuse angeordnet ist und einem aus einem elektrisch leitfähigen Werkstoff gefertigten Schirm, der auf der dem Benutzer zugewandten Seite der Abdeckplatte auf dieser befestigt ist,
- Figur 2: ein zweites Ausführungsbeispiel einer kapazitiven Benutzerschnittstelle bestehend aus einer Abdeckplatte aus Kunststoff oder Glas, die zwischen der Schaltfiläche und einer ein Kapazitätsfeld erzeugenden Sensorfläche in einem Gehäuse angeordnet ist und einem aus einem elektrisch leitfähigen Werkstoff gefertigten Schirm, wobei in die Abdeckplatte eine Vielzahl von Aussparungen eingearbeitet sind in die jeweils einer der Schirme eingesetzt und lageorientiert gehalten ist und
- Figur 3: eine Schnittdarstellung der Benutzerschnittstelle gemäß Figur 2.

In den Figuren 1 und 2 ist jeweils eine kapazitive Bedienschnittstelle 1, durch die ein nicht dargestelltes elektrisches Gerät, beispielsweise ein Smartphone, eine Werkzeugmaschine, ein Backofen, Herd, Kühlschrank oder dergleichen, durch die Berührung eines menschlichen Fingers oder eines Bedienstiftes steuerbar sein soll. Die von außen zugängliche Oberfläche bzw. die Bedienrichtung ist dabei mit der Bezugsziffer 2 gekennzeichnet.

Die kapazitive Bedienschnittstelle 1 besteht aus einem Gehäuse 3 und einer in eine in dem Gehäuse 3 vorgesehenen Aussparung eingesetzten Abdeckplatte 4, die aus einem elektrisch nicht leitfähigen und transparenten Werkstoff, beispielsweise aus einem Kunststoff oder Glas gefertigt ist. Durch das Gehäuse 3 und die Abdeckplatte 4 wird ein Innenraum gebildet, in dem eine Vielzahl von Sensorflächen 6 angeordnet sind. Die jeweilige Sensorfläche 6 ist dabei auf einer Leiterplatte 7 befestigt und wird von dieser bestromt, so dass die aus einem metallischen Werkstoff hergestellte Sensorfläche 6 eine erste kapazitive Platte bildet und in Richtung der Abdeckplatte 4 ein Kapazitätsfeld ausstrahlt, das die elektrisch nicht leitfähige Abdeckplatte 4 durchdringt. Sobald ein menschlicher Finger oder ein geeignetes Bedienelement in das jeweilige von der Sensorflächen 6 abgestrahlte Kapazitätsfeld eindringt, entsteht eine Kapazitätsfeldänderung, die mittels einer elektrischen Steuer- Auswerteeinheit 15, die mit der Leiterplatte 7 gekoppelt sind, ausgewertet und in ein elektrisches Schaltsignal umgewandelt sind.

Der Abdeckplatte 4 sind dabei unterschiedliche Schaltflächen 5 zugeordnet, die fluchtend zu der jeweils darunterliegenden Sensorfläche 6 angeordnet sind, so dass die jeweilige Schaltfläche 5 einem exakt zugeordneten Kapazitätsfeld der jeweiligen Sensorfläche 6 entspricht.

Auf der dem Benutzer zugewandten Seite der Abdeckplatte 4 bzw. in einer Blickrichtung 2 vor der Abdeckplatte 4, ist gemäß Figur 1 ein flächig ausgestalteter Schirm 11 angebracht, der aus einem elektrisch leitfähigen Werkstoff gefertigt ist und im Verhältnis zu der Abdeckplatte 4 eine hohe Wärmeleitfähigkeit aufweist. Ein Benutzer erkennt folglich die Schaltflächen 5 auf der Abdeckplatte 4 dadurch, dass in den Schirm 11 eine vollständig durchdringende Durchbrechung 12 eingearbeitet ist, die einen Spalt 12' bilden und durch die der einer Schaltfläche 5 zugeordnete Schirm 11 elektrisch isoliert ist. Durch die Durchbrechung 12 tritt ein elektrisches Feld hindurch, so dass durch die Sensorfläche 6 eine durch den Benutzer bewirkte Veränderung des elektrischen Feldes erfassbar ist und ein elektrisch auswertbares Schaltsignal geniert werden kann.

Der Schirm 11 kann aus einem flächig und elektrisch leitfähigen Werkstoff auf die Abdeckplatte 4 aufgelegt werden. Mittels Laserstrahlen, einer Fräsung oder dergleichen, können die vollständig durchdringenden Durchbrechungen 12 bzw. die Spalten 12' in den Schirm 11 eingebracht werden. Auch können die einzelnen Schaltflächen 5 durch Umspritzen von Metallplatten oder das Aufkleben von Metallplatten auf einen Kunststoffträger erzeugt werden. Die Durchbrechungen 12 verlaufen dabei fluchtend oder seitlich versetzt zu der jeweiligen Schaltfläche 5. Darüber hinaus kann in den Schirm 11 ein Symbol, eine Beschriftung oder dergleichen eingebracht werden, um beispielsweise die Funktion einer Schaltfläche 5 visuell darzustellen. Auch kann auf den Schirm 11 ein von diesem abstehendes Punktmuster oder Symbole aufgebracht oder angebracht werden, so dass die Funktion der Schaltfläche 5 durch die Fingerspitzen des Benutzers zu ertasten sind.

Bei der Berührung des Schirms 11 durch den Benutzer erfährt dieser aufgrund des erhöhten Wärmeüberganges des Schirms 11 die besondere haptische Wahrnehmung der Schaltfläche 5. Durch diese Thermorezeption entsteht für den Benutzer der Eindruck, dass der Schirm 11 bzw. die Schaltfläche 5 kühl ist und ihm wird ein besonders hochwertiger Eindruck der kapazitiven Benutzerschnittstelle 1 vermittelt.

Die Abdeckplatte 4 ist aus einem transparenten oder semitransparenten Werkstoff hergestellt. Zwischen der Sensorfläche 6 und der Abdeckplatte 4 sind ein oder mehrere Beleuchtungsmittel 8, insbesondere LEDs angeordnet, deren Lichtwellen 10 die Abdeckplatte 4 durchdringen und von dem Benutzer durch die Durchbrechung 12 wahrnehmbar ist. Zwischen den Beleuchtungsmitteln 8 zweier benachbarter Schaltflächen 5 sind ein oder mehrere Abstandshalter 9 angeordnet, die die jeweiligen Schaltflächen 5 lichtdicht trennen.

Die Beleuchtungsmittel 8 sind mit einer elektrischen Steuer- und Auswertevorrichtung 15 verbunden und in Abhängigkeit von der gemessenen Kapazitätsfeldänderung auf der Schaltfläche 5 können diese derart gestaltet werden, dass die Farbe der Lichtwellen 10 veränderbar ist, oder dass die Beleuchtungsmittel 8 aus bzw. eingeschaltet sind.

Der Figur 2 ist zu entnehmen, dass in die Abdeckplatte 4 jeweils eine Aussparung 13 eingearbeitet ist, in die der jeweilige Schirm 11 eingesetzt und durch diese lageorientiert gehalten ist. Die Abdeckplatte 4 hält demnach die der Schaltfläche 5 zugeordneten Schirme 11 voneinander elektrisch isoliert und beabstandet. Die Außenkontur des Schirms 11 und die Innenkontur der Aussparung 13 sind zueinander korrespondierend, so dass der in die Aussparung 13 eingesetzte Schirm 11 fluchtend zu der von der Abdeckplatte 4 gebildeten Ebene verläuft und aus dieser nicht übersteht.

Gleichwohl kann der jeweilige Schirm 11 auch konkav oder konvex gekrümmt sein, so dass entsprechend wahrnehmbare Erhebungen oder Vertiefungen gebildet sind. Darüber hinaus kann der Schirm 11 auch Punkte oder Striche aufweisen, die einem Buchstaben oder Zahl der Blindenschrift entsprechen.

Darüber hinaus ist die Abdeckplatte 4 mit dem in diese eingearbeiteten Aussparungen 13 derart ausgestaltet, dass zwischen den benachbarten Schirmen 11 ein Spalt 12' entsteht, durch den das von der Sensorfläche 6 abgestrahlte Kapazitätsfeld durchlaufen ist. Folglich werden Kapazitätsfeldveränderungen festgestellt, die seitlich neben einem Schirm 11 stattfinden. Des Weiteren kann in den jeweiligen Schirm 11 auch eine der in der Figur 1 abgebildeten Durchbrechungen 12 eingearbeitet sein. Durch entsprechend elektrische Auswertungen der Kapazitätsfeldveränderungen der jeweiligen Sensorfläche 6 kann dann festgestellt werden, welche Schaltfläche 5 der Benutzer tatsächlich aktivieren wollte.

Eine Änderung des Kapazitätsfeldes ist durch die Sensorfläche durch die Abdeckplatte 4 erfasst und ein Schaltsignal kann in Abhängigkeit der betätigten Schaltfläche 5 generiert werden.

Insbesondere der Figur 3 ist die elektrische Entkopplung des Schirms 11 durch die Abdeckplatte 4 zu entnehmen. Der Schirm 11 der jeweiligen Schaltfläche 5 ist durch den elektrisch nicht leitfähigen Werkstoff der Abdeckplatte 4 vollständig umgeben, so dass durch diesen Spalt 12' eine Veränderung des Kapazitätsfeldes durch die Sensorfläche 6 erfasst ist.

Die Steuer- und Auswerteeinheit 15 erfasst die Änderung des Kapazitätsfeldes in x - y - Koordinaten und kann die Veränderung des Kapazitätsfeldes auf der Sensorfläche 6 einer Schaltfläche 5 zuordnen. Ein entsprechender Algorithmus in der Steuer- und Auswerteeinheit 15 kann die Zuordnung der Benutzereingabe und der Schaltfläche 5 verbessern.

Die dem Benutzer zugewanderten Seite des Schirms 11 kann in einer Ebene mit der Abdeckplatte 4 oder beabstandet zu der Abdeckplatte 4 angeordnet sein. Somit ist anhand eines Höhenreliefs die Schaltfläche 5 mittels des Tastsinnes erfassbar.

## Patentansprüche

1. Kapazitive Benutzerschnittstelle (1) zur Erzeugung mindestens eines elektrisch auswertbaren Schaltsignals, durch das ein elektrisches Gerät, beispielsweise ein Telefon, eine Werkzeugmaschine, ein Kühlschrank oder dergleichen manuell bedienbar ist,
- mit einer in einem Gehäuse (3) angeordneten Abdeckplatte (4), die aus einem elektrisch nicht leitfähigen Werkstoff hergestellt ist, und durch die mindestens eine Schaitffäche (5) erkennbar und von außen bedienbar ist,
- mit mindestens einer ein Kapazitätsfeld erzeugende Sensorfläche (6), die aus einem elektrisch leitfähigen Werkstoff hergestellt und die auf eine im Inneren des Gehäuses (3) an vorgesehenen Träger- oder Leiterplatten (7) aufgebracht ist und die fluchtend zu der jeweiligen Schaltfläche (5) ausgerichtet ist und
- mit einer Spannungsquelle (14) zur Bestromung der Sensorfläche (6),
**dadurch gekennzeichnet,**
**dass** auf oder in der Abdeckplatte (4) mindestens ein flächig ausgestalteter Schirm (11) vorgesehen ist, der aus einem elektrisch leitfähigen Werkstoff besteht, und dass in den Schirm (11) und/oder seitlich benachbart zu dem jeweiligen Schirm (11) mindestens eine den Schirm (11) vollständig durchdringende Durchbrechung (12) bzw. ein Spalt (12') vorhanden ist, die zu der jeweiligen Schaltfläche (5) fluchtend und/oder seitlich versetzt verläuft.

2. Benutzerschnittstelle (1) nach Anspruch 1,
**dadurch gekennzeichnet,**
**dass** die in die Abdeckplatte (4) für jeden Schirm eine Aussparung (13) eingearbeitet ist, in die der jeweilige Schirm (11) fest einsetzbar und in dieser lageorientiert gehalten ist.

3. Benutzerschnittstelle (1) nach einem der vorgenannten Ansprüche,
**dadurch gekennzeichnet,**
das die Schaltflächen (5) durch Lasern, Freifräsen, Umspritzen oder Aufkleben des Schirms (11) gebildet sind.

4. Benutzerschnittstelle (1) nach einem der vorgenannten Ansprüche,
**dadurch gekennzeichnet,**
**dass** sich die flächige Abmessung des Schirms (11) an die Abmessung der Abdeckplatte (4) angepasst ist und sich über deren gesamte Fläche erstreckt, oder dass der Schirm (11) vereinzelt auf oder in der Abdeckplatte (4) angeordnet ist und das zwischen zwei benachbarten Schirmen (11) ein Spalt (12') vorhanden ist.

5. Benutzerschnittstelle (1) nach Anspruch 1 oder 2,
**dadurch gekennzeichnet,**
**dass** die Oberflächen der jeweiligen Schirme (11) in einer Ebene mit der Oberfläche der Abdeckplatte (4) verlaufen.

6. Benutzerschnittstelle (1) nach Anspruch 1 oder 2,
**dadurch gekennzeichnet,**
**dass** der Schirm (11) eine plane, konkave, oder konvex gekrümmte oder gewellte Außenkontur aufweist, die an der von der Abdeckplatte (4) gebildeten Ebene übersteht oder in dieser verläuft.

7. Benutzerschnittstelle (1) nach einem der vorgenannten Ansprüche,
**dadurch gekennzeichnet,**
**dass** der Schirm (11) aus Metall hergestellt ist und/oder eine im Vergleich zu Kunststoff hohe Wärmeleifähigkeit besitzt.

8. Benutzerschnittstelle (1) nach einem der vorgenannten Ansprüche,
**dadurch gekennzeichnet,**
**dass** die Abdeckplatte (4) aus einem transparenten oder semitransparenten Werkstoff gebildet ist.

9. Benutzerschnittstelle (1) nach Anspruch 7,
**dadurch gekennzeichnet,**
**dass** in dem Gehäuse (3) ein oder mehrere Beleuchtungsmittel (8) angeordnet sind, deren ausgestrahlte Lichtwellen (10) durch die Abdeckplatte (4) hindurch für den Benutzer wahrnehmbar ist.

10. Benutzerschnittstelle (1) nach Anspruch 7 oder 8,
**dadurch gekennzeichnet,**
**dass** zwischen den Beleuchtungsmittel (8) zweier benachbarter Schaltfläche (5) ein Abstandshalter (9) angeordnet ist, und dass der Abstandshalter (9) die benachbarten Schaltflächen (5) lichtdicht trennt.

11. Benutzerschnittstelle (1) nach einem der vorgenannten Ansprüche
**dadurch gekennzeichnet,**
**dass** die jeweilige Sensorfläche (6) mit einem IC-Schaltkreis der Steuer- und Auswerteeinrichtung (15) elektrisch gekoppelt ist, durch die die Veränderungen des von der jeweiligen Sensorfläche (6) erzeugten Kapazitätsfeldes (2) im Bereich der Schaltfläche (5) in X- und/oder Y-Richtung bezogen auf das X-Y-Koordinatensystem (17) der Schaltfläche (5) erfassbar sind.

12. Benutzerschnittstelle (1) nach Anspruch 10,
**dadurch gekennzeichnet,**
**dass** durch eine elektrische Steuer- und Auswertevorrichtung (16), vorzugsweise einen Mikrocontroller, Mikroprozessor oder einen integrierten Schaltkreis, die jeweiligen Beleuchtungsmittel (8) elektrisch verbunden sind und dass in Abhängigkeit von der gemessenen bzw. erfassten Kapazitätsfeldveränderungen auf der Schaltfläche (5) der Abdeckplatte (4) die Beleuchtungsmittel (8) durch die elektrische Steuereinrichtung (15) derart geschaltet sind, dass die Farbe der Lichtwellen (10) veränderbar ist oder dass die Beleuchtungsmittel (8) aus- bzw. eingeschaltet sind.
